# DEMANDE DE BREVET EUROPEEN

(11) **EP 4 280 283 A1**
(43) Date de publication de la demande: **22.11.2023**
(21) Numéro de dépôt: 23172376.8
(22) Date de dépôt: 09.05.2023
(51) Int. Cl.: H01L 27/146, H04N 5/00

(54) **CAPTEUR D'IMAGES**

(30) Priorité: 19.05.2022 FR 2204780
(71) Demandeur: Commissariat à l'énergie atomique et aux énergies alternatives, 75015 Paris (FR)
(72) Inventeur: PALMIGIANI, Gaelle, 38054 GRENOBLE CEDEX 09 (FR); DENEUVILLE, François, 38054 GRENOBLE CEDEX 09 (FR); SAXOD, Oliver, 38054 GRENOBLE CEDEX 09 (FR)
(74) Mandataire: Cabinet Beaumont

(57) **Abrégé**

La présente description concerne un capteur d'images comprenant une pluralité de photosites (100) formés dans et sur un substrat semiconducteur (101), chaque photosite comportant :
- une première zone photosensible (103) formée dans le substrat semiconducteur et adaptée à capter de la lumière dans une première gamme de longueurs d'onde ;
- une deuxième zone photosensible (107) formée dans le substrat semiconducteur à l'aplomb de la première zone photosensible (103) et adaptée à capter de la lumière dans une deuxième gamme de longueurs d'onde, différente de la première gamme de longueurs d'onde ;
- une première zone (117) de collecte de charges photogénérées dans les première et deuxième zones photosensibles, disposée du côté d'une face (101T) du substrat opposée à la première zone photosensible (103) ;
- une première grille de transfert (VEGA), s'étendant verticalement depuis la première zone photosensible (103) jusqu'à ladite face (101T), adaptée à transférer les charges photogénérées dans la première zone photosensible (103) vers la deuxième zone photosensible (107) ; et
- une deuxième grille de transfert (119), s'étendant horizontalement sur ladite face (101T) à l'aplomb de la deuxième zone photosensible (107), adaptée à transférer les charges photogénérées depuis la deuxième zone photosensible (107) vers la première zone de collecte de charges (117).

## Description

### Domaine technique

La présente description concerne de façon générale le domaine des dispositifs d'acquisition d'images. La présente description concerne plus particulièrement des dispositifs d'acquisition d'images adaptés à acquérir une image 2D et une image de profondeur d'une scène au moyen d'un même réseau de pixels.

### Technique antérieure

On connaît des dispositifs d'acquisition d'images capables d'acquérir une image 2D et une image de profondeur d'une scène. On connaît notamment des dispositifs comportant des pixels d'image 2D et des pixels de profondeur faisant partie d'un même réseau de pixels d'un capteur d'images.

### Résumé de l'invention

Il existe un besoin d'améliorer les dispositifs d'acquisition d'une image 2D et d'une image de profondeur d'une scène existants. Il serait plus précisément souhaitable de faciliter l'intégration de pixels de profondeur dans un réseau de pixels d'un capteur d'images adapté à acquérir des images 2D et des images de profondeur.

Un objet d'un mode de réalisation est de pallier tout ou partie des inconvénients des dispositifs d'acquisition d'une image 2D et d'une image de profondeur d'une scène connus. Un mode de réalisation a plus précisément pour objectif de faciliter l'intégration de pixels de profondeur dans un réseau de pixels d'un capteur d'images adapté à acquérir des images 2D et des images de profondeur.

Pour cela, un mode de réalisation prévoit un capteur d'images comprenant une pluralité de photosites formés dans et sur un substrat semiconducteur, chaque photosite comportant :
- une première zone photosensible formée dans le substrat semiconducteur et adaptée à capter de la lumière dans une première gamme de longueurs d'onde ;
- une deuxième zone photosensible formée dans le substrat semiconducteur à l'aplomb de la première zone photosensible et adaptée à capter de la lumière dans une deuxième gamme de longueurs d'onde, différente de la première gamme de longueurs d'onde ;
- une première zone de collecte de charges photogénérées dans les première et deuxième zones photosensibles, disposée du côté d'une face du substrat opposée à la première zone photosensible ;
- une première grille de transfert, s'étendant verticalement depuis la première zone photosensible jusqu'à ladite face, adaptée à transférer les charges photogénérées dans la première zone photosensible vers la deuxième zone photosensible ; et
- une deuxième grille de transfert, s'étendant horizontalement sur ladite face à l'aplomb de la deuxième zone photosensible, adaptée à transférer les charges photogénérées depuis la deuxième zone photosensible vers la première zone de collecte de charges.

Selon un mode de réalisation, chaque photosite comporte en outre :
- au moins une deuxième zone de collecte de charges photogénérées dans la deuxième zone photosensible, disposée du côté de ladite face ; et
- au moins une troisième grille de transfert s'étendant latéralement, sur ladite face, à l'aplomb de la deuxième zone photosensible.

Selon un mode de réalisation, chaque photosite comporte en outre :
- une troisième zone photosensible, interposée entre les première et deuxième zones photosensibles ; et
- une quatrième grille de transfert s'étendant verticalement, depuis la troisième zone photosensible, jusqu'à ladite face et adaptée à transférer les charges photogénérées dans la troisième zone photosensible vers la deuxième zone photosensible.

Selon un mode de réalisation, la première zone de collecte de charges est commune aux charges photogénérées dans les première, deuxième et troisième zones photosensibles.

Selon un mode de réalisation, la première grille de transfert entoure la quatrième grille de transfert.

Selon un mode de réalisation, chaque photosite comporte en outre une tranchée d'isolation périphérique s'étendant verticalement dans le substrat semiconducteur, depuis ladite face, et délimitant latéralement la première zone photosensible.

Selon un mode de réalisation, chaque photosite comporte en outre un circuit de commande configuré pour appliquer alternativement, sur la première grille de transfert :
- un premier potentiel adapté à bloquer un transfert de charges depuis la première zone photosensible vers la deuxième zone photosensible ; et
- un deuxième potentiel, différent du premier potentiel, adapté à permettre un transfert de charges depuis la première zone photosensible vers la deuxième zone photosensible.

Selon un mode de réalisation, le circuit de commande est configuré pour appliquer alternativement, sur la deuxième grille de transfert :
- un troisième potentiel adapté à bloquer un transfert de charges depuis la deuxième zone photosensible vers la première zone de stockage de charges ; et
- un quatrième potentiel, différent du troisième potentiel, adapté à permettre un transfert de charges depuis la deuxième zone photosensible vers la première zone de stockage de charges.

Selon un mode de réalisation, le capteur comprend en outre une cinquième grille de transfert s'étendant horizontalement sur ladite face à l'aplomb de la deuxième zone photosensible, la cinquième grille de transfert étant adaptée à transférer des charges photogénérées depuis la deuxième zone photosensible vers une deuxième zone de collecte de charges.

Selon un mode de réalisation, les deuxième et cinquième grilles de transfert sont successivement ouvertes lors d'une phase d'échantillonnage de charges photogénérées dans la deuxième zone photosensible.

Selon un mode de réalisation, les deuxième et cinquième grilles de transfert sont reliées entre elles par un commutateur.

Selon un mode de réalisation, les premières et deuxièmes zones photosensibles des photosites du capteur sont destinées à capturer respectivement une image 2D et une image de profondeur d'une scène.

Selon un mode de réalisation, les première et deuxième zones photosensibles sont dopées du même type de conductivité.

Selon un mode de réalisation, la première zone photosensible est dopée d'un premier type de conductivité et la deuxième zone photosensible est dopée d'un deuxième type de conductivité, opposé au premier type de conductivité.

Un mode de réalisation prévoit un dispositif comprenant :
- un capteur d'images tel que décrit ;
- une source d'émission d'un rayonnement infrarouge ; et
- un circuit de commande de la source d'émission du rayonnement infrarouge et du capteur d'images.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue de dessus, schématique et partielle, d'un photosite de capteur d'images selon un mode de réalisation ;
la figure 2A est une vue en coupe, selon le plan AA de la figure 1, du photosite de la figure 1 ;
la figure 2B est une vue en coupe, selon le plan BB de la figure 1, du photosite de la figure 1 ;
la figure 3 est une vue en coupe, schématique et partielle, d'un capteur d'images comprenant plusieurs photosites du type du photosite de la figure 1 selon un mode de réalisation ;
la figure 4 est un schéma électrique d'un circuit de commande du photosite de la figure 1 selon un mode de réalisation ;
la figure 5 est un schéma électrique d'un circuit de commande du photosite de la figure 1 selon un autre mode de réalisation ;
la figure 6 est chronogramme illustrant un mode de mise en oeuvre d'un procédé de commande de photosites du capteur d'images de la figure 3 ;
la figure 7 est un schéma électrique d'un circuit de commande de quatre photosites du type du photosite de la figure 1 selon un mode de réalisation ;
la figure 8 est une vue de dessus, schématique et partielle, d'un photosite de capteur d'images selon un autre mode de réalisation ;
la figure 9 est un schéma électrique d'un circuit de commande du photosite de la figure 8 selon un mode de réalisation ;
la figure 10 est une vue de dessus, schématique et partielle, d'un photosite de capteur d'images selon encore un autre mode de réalisation ; et
la figure 11A est une vue en coupe, selon le plan AA de la figure 10, du photosite de la figure 10.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les circuits de lecture, ou décodeurs colonnes, les circuits de commande, ou décodeurs lignes, et les applications dans lesquelles peuvent être prévus des capteurs d'images n'ont pas été détaillés, les modes de réalisation et variantes décrits étant compatibles avec les circuits de lecture et les circuits de commande des capteurs d'images usuels, ainsi qu'avec les applications usuelles mettant en oeuvre des capteurs d'images.

En outre, la polarisation du caisson MOS et les couches de passivation situées le long des flancs des grilles de transfert verticales et des tranchées d'isolation ne sont pas détaillées.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, « transmittance d'une couche » désigne un rapport entre l'intensité du rayonnement sortant de la couche et l'intensité du rayonnement entrant dans la couche. Dans la suite de la description, une couche ou un film est dit opaque à un rayonnement lorsque la transmittance du rayonnement au travers de la couche ou du film est inférieure à 10 %. Dans la suite de la description, une couche ou un film est dit transparent à un rayonnement lorsque la transmittance du rayonnement au travers de la couche ou du film est supérieure à 10 %.

Dans la suite de la description, « lumière visible » désigne un rayonnement électromagnétique dont la longueur d'onde est comprise entre 380 et 780 nm et « rayonnement infrarouge » désigne un rayonnement électromagnétique dont la longueur d'onde est comprise entre 780 nm et 15 µm. En outre, « rayonnement infrarouge proche » désigne plus précisément un rayonnement électromagnétique dont la longueur d'onde est comprise entre 750 nm et 1,1 µm.

Un pixel d'une image correspond à l'élément unitaire de l'image captée par un capteur d'images. Lorsque le capteur d'images est un capteur d'images couleur, il comprend en général, pour chaque pixel de l'image couleur à acquérir, un groupe d'au moins trois photosites. Chacun de ces trois photosites effectue l'acquisition d'un rayonnement lumineux sensiblement dans une seule couleur (par exemple le rouge, le vert ou le bleu), par exemple dans une plage de longueurs d'onde inférieure à 100 nm. Lorsque le capteur d'images est un capteur d'images de profondeur, il peut comprendre, pour chaque pixel de l'image de profondeur à acquérir, un ou plusieurs photosites permettant chacun d'acquérir une partie de l'information de profondeur.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence sauf précision contraire à l'orientation des figures.

Sauf précision contraire, les expressions « environ », « approximativement », « sensiblement », et « de l'ordre de » signifient à 10 % près, de préférence à 5 % près.

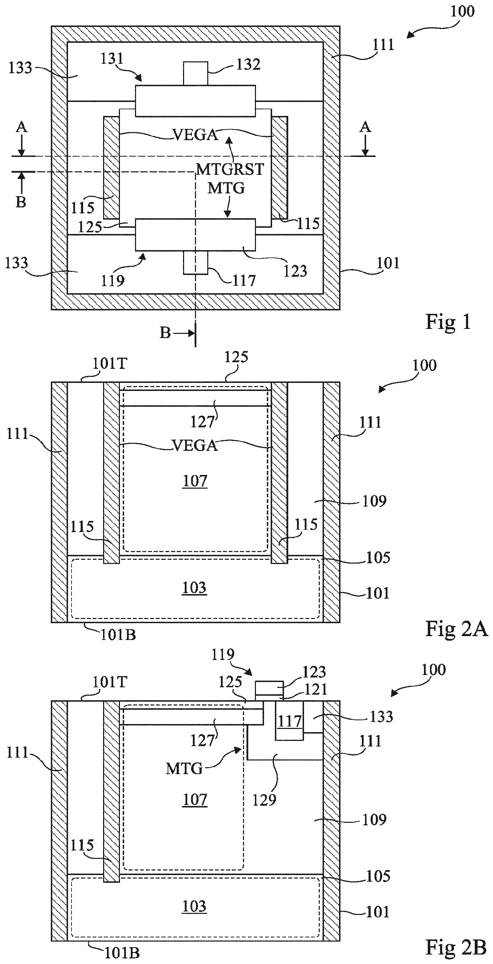

La figure 1 est une vue de dessus, schématique et partielle, d'un photosite 100 de capteur d'images selon un mode de réalisation. Les figures 2A et 2B sont des vues en coupe, selon les plans AA et BB de la figure 1, respectivement, du photosite 100 de la figure 1.

Dans l'exemple représenté, le photosite 100 est formé dans et sur un substrat semiconducteur 101, par exemple en silicium. À titre d'exemple, le substrat 101 présente une épaisseur comprise entre 3 et 20 µm.

Dans cet exemple, le photosite 100 comporte une première zone photosensible 103 formée dans le substrat semiconducteur 101. Comme illustré en figures 2A et 2B, la première zone photosensible 103 s'étend verticalement dans l'épaisseur du substrat semiconducteur 101 depuis une face inférieure 101B du substrat 101 jusqu'à une profondeur inférieure à l'épaisseur du substrat 101. Dans l'exemple illustré, la première zone photosensible 103 du photosite 100 présente, vue de dessus, un pourtour de forme sensiblement carrée. La première zone photosensible 103 est par exemple formée dans une première région 105 du substrat semiconducteur 101 dopée d'un premier type de conductivité, par exemple le type N, et présentant un niveau de dopage N1.

La première zone photosensible 103 peut par exemple constituer une première diode photosensible D1, ou photodiode, par exemple une photodiode pincée présentant une tension de pincement Vpin1.

Dans l'exemple représenté, le photosite 100 comporte en outre une deuxième zone photosensible 107 formée dans le substrat semiconducteur 101. La deuxième zone photosensible 107 est située à l'aplomb de la première zone photosensible 103 (au-dessus de la première zone photosensible 103, dans l'orientation des figures 2A et 2B). Dans l'exemple illustré, la deuxième zone photosensible 107 s'étend verticalement dans l'épaisseur du substrat semiconducteur 101, depuis une face supérieure 101T du substrat 101 opposée à la face inférieure 101B, jusqu'à une profondeur inférieure à l'épaisseur du substrat 101. Vue de dessus, la deuxième zone photosensible 107 présente par exemple un pourtour de forme rectangulaire. La deuxième zone photosensible 107 présente par exemple des dimensions latérales inférieures à celles de la première zone photosensible 103. Plus précisément, en vue de dessus, le rectangle formé par la deuxième zone photosensible 107 est inscrit à l'intérieur du carré formé par la première zone photosensible 103. La deuxième zone photosensible 107 est par exemple formée dans une deuxième région 109 du substrat 101 dopée du premier type de conductivité, le type N dans cet exemple, et présentant un niveau de dopage N2. Le taux de dopage N2 de la deuxième région 109 du substrat 101 est par exemple supérieur au niveau de dopage N1 de la première région 105. Dans l'exemple représenté, la deuxième région 109 du substrat 101 est en contact, par sa face inférieure, avec la face supérieure de la première région 105 sous-jacente. En outre, dans cet exemple, la deuxième zone photosensible 107 est sensiblement en contact, par sa face inférieure, avec la face supérieure de la première zone photosensible 103 sous-jacente.

La deuxième zone photosensible 107 peut par exemple constituer une deuxième diode photosensible D2, par exemple une photodiode pincée présentant une tension de pincement Vpin2. Dans cet exemple, la tension de pincement Vpin2 de la deuxième photodiode D2 est supérieure à la tension de pincement Vpin1 de la première photodiode D1.

Chaque zone photosensible 103, 107 est par exemple destinée à collecter des photons incidents, lors de phases d'illumination du capteur d'images dont fait partie le photosite 100, et à convertir ces photons en paires électron-trou. Dans cet exemple, la première zone photosensible 103 est adaptée à capter de la lumière dans une première gamme de longueurs d'onde et la deuxième zone photosensible 107 est adaptée à capter de la lumière dans une deuxième gamme de longueurs d'onde, différente de la première gamme de longueurs d'onde. Les première et deuxième zones photosensibles 103 et 107 sont par exemple destinées à capturer respectivement des images 2D et des images de profondeur d'une scène. À titre d'exemple, la première zone photosensible 103 du photosite 100 est adaptée à capter de la lumière visible, par exemple de la lumière bleue, et la deuxième zone photosensible 107 du photosite 100 est adaptée à capter un rayonnement infrarouge, par exemple un rayonnement infrarouge proche, lorsque le photosite 100 est illuminé du côté de sa face inférieure 101B.

Dans un cas où les première et deuxième zones photosensibles 103 et 107 sont en le même matériau, par exemple le silicium, la lumière visible et le rayonnement infrarouge sont absorbés majoritairement à des profondeurs différentes dans le substrat semiconducteur 101 depuis sa face inférieure 101B. Dans ce cas, la profondeur d'absorption majoritaire de la lumière visible est inférieure à celle du rayonnement infrarouge. La deuxième zone photosensible 107 peut par exemple présenter une épaisseur supérieure à celle de la première zone photosensible 103 afin d'optimiser l'absorption du rayonnement infrarouge dans la deuxième zone photosensible 107.

Dans l'exemple représenté, le photosite 100 comporte en outre une tranchée d'isolation périphérique 111, par exemple une tranchée d'isolation capacitive, délimitant latéralement la première zone photosensible 103. Plus précisément, dans cet exemple, la tranchée d'isolation périphérique 111 borde toutes les faces latérales de la première zone photosensible 103 et présente, en vue de dessus, un pourtour de forme sensiblement carrée.

La tranchée d'isolation périphérique 111 permet d'isoler électriquement les première et deuxième zones photosensibles 103 et 107 du photosite 100 par rapport aux zones photosensibles des photosites voisins, non représentés en figures 1, 2A et 2B. La tranchée d'isolation périphérique 111 est formée dans le substrat 101. Dans l'orientation des figures 2A et 2B, la tranchée d'isolation périphérique 111 s'étend verticalement dans l'épaisseur du substrat 101, depuis la face supérieure 101T du substrat 101, jusqu'à la face inférieure 101B du substrat 101. En d'autres termes, la tranchée d'isolation périphérique 111 s'étend verticalement, dans cet exemple, sur toute l'épaisseur du substrat 101 et débouche du côté des faces supérieure 101T et inférieure 101B du substrat 101.

La tranchée d'isolation périphérique 111 présente par exemple une largeur comprise entre 30 et 600 nm, et une profondeur comprise entre 5 et 20 µm. Dans l'exemple illustré en figures 2A et 2B, la tranchée d'isolation périphérique 111 présente une profondeur égale à l'épaisseur du substrat 101.

Bien que cela n'ait pas été détaillé en figures 1, 2A et 2B, la tranchée d'isolation périphérique 111 comporte par exemple une région électriquement conductrice dont les parois latérales sont revêtues d'une couche électriquement isolante. Cette couche isole électriquement la région électriquement conductrice de la tranchée 111 par rapport au substrat 101. À titre d'exemple, la région électriquement conductrice de la tranchée 111 est en silicium polycristallin ou en un métal, par exemple le cuivre, ou en un alliage métallique, et la couche électriquement isolante de la tranchée 111 est en un matériau diélectrique, par exemple en oxyde de silicium. À titre d'exemple, la tranchée d'isolation périphérique 111 est une tranchée de type CDTI (de l'anglais « Capacitive Deep Trench Isolation »), ou tranchée profonde d'isolation capacitive.

Dans l'exemple illustré en figures 1, 2A et 2B, le photosite 100 comporte en outre une grille de transfert verticale VEGA adaptée à transférer les charges photogénérées dans la première zone photosensible 103 vers la deuxième zone photosensible 107. Plus précisément, un circuit de commande du photosite 100 peut être utilisé pour appliquer alternativement, sur la grille de transfert verticale VEGA :
- un premier potentiel adapté à bloquer un transfert de charges depuis la première zone photosensible 103 vers la deuxième zone photosensible 107 ; ou
- un deuxième potentiel, différent du premier potentiel, adapté à permettre un transfert de charges depuis la première zone photosensible 103 vers la deuxième zone photosensible 107.

Dans cet exemple, la grille de transfert verticale VEGA comprend deux tranchées d'isolation 115 disjointes, par exemple des tranchées d'isolation capacitives. Comme illustré en figures 2A et 2B, chaque tranchée d'isolation 115 de la grille de transfert verticale VEGA s'étend verticalement dans l'épaisseur du substrat semiconducteur 101 depuis la face supérieure 101T du substrat 101 jusqu'à la première zone photosensible 103, et pénètre partiellement dans la première zone photosensible 103 jusqu'à une profondeur inférieure à celle de la tranchée d'isolation périphérique 111. En d'autres termes, chaque tranchée d'isolation 115 s'interrompt dans l'épaisseur de la première région 105 du substrat 101 et ne débouche pas du côté de la face inférieure 101B du substrat 101. Dans cet exemple, chaque tranchée d'isolation 115 traverse totalement la deuxième région 109 du substrat 101 et pénètre partiellement dans la première région 105. À titre d'exemple, chaque tranchée d'isolation 115 présente une profondeur comprise entre 3 et 18 µm.

Dans l'exemple représenté, les tranchées d'isolation 115 forment deux plaques sensiblement parallèles entre elles et bordant deux faces latérales opposées de la deuxième zone photosensible 107. Dans cet exemple, les tranchées d'isolation 115 sont en outre, vues de dessus, sensiblement parallèles à deux côtés opposés de la tranchée d'isolation périphérique 111.

De manière générale, la grille de transfert verticale VEGA comprend au moins des première et deuxième plaques parallèles entre elles, chaque plaque comprenant par exemple une plaque conductrice revêtue d'une couche isolante, la deuxième zone photosensible 107 s'étendant latéralement depuis une face de la première plaque jusqu'à une face de la deuxième plaque située en regard de la première plaque. Dit autrement, la deuxième zone photosensible 107 s'étend à l'intérieur d'un volume délimité latéralement par au moins deux plaques faisant partie de la grille de transfert verticale VEGA.

Dans cet exemple, les tensions de pincement Vpin1 et Vpin2 des diodes D1 et D2 peuvent être ajustées en modifiant les niveaux de dopage N1 et N2 des zones photosensibles 103 et 107. Les tensions Vpin1 et Vpin2 peuvent en outre être ajustées en modifiant respectivement une distance entre les deux murs opposés de la tranchée d'isolation périphérique 111 parallèles aux tranchées d'isolation 115 et la largeur de la grille de transfert verticale VEGA, autrement dit la distance entre les deux tranchées d'isolation 115. Les tensions Vpin1 et Vpin2 dépendent en outre d'une tension de polarisation d'une couche d'inversion passivant les flancs de la tranchée 111, pour la zone photosensible 103, et des tranchées 115, pour la zone photosensible 107. Cette tension de polarisation est par exemple identique pour les deux zones photosensibles 103 et 107. Dans cet exemple, la tension de polarisation de la couche d'inversion ne permet pas d'ajuster les tensions de pincement Vpin1 et Vpin2 indépendamment l'une de l'autre.

Chaque tranchée d'isolation 115 de la grille de transfert verticale VEGA présente par exemple une structure analogue à celle de la tranchée d'isolation périphérique 111. Plus précisément, bien que cela n'ait pas été détaillé en figures 1, 2A et 2B, chaque tranchée d'isolation 115 comporte par exemple une région électriquement conductrice, par exemple en silicium polycristallin ou en un métal, par exemple le cuivre, ou en un alliage métallique. La région électriquement conductrice de chaque tranchée d'isolation 115 est par exemple en le même matériau que la région électriquement conductrice de la tranchée d'isolation périphérique 111. En outre, chaque tranchée 115 comporte par exemple une couche électriquement isolante revêtant les parois latérales et la face inférieure de la région électriquement conductrice. Cette couche isole électriquement la région électriquement conductrice de la tranchée 115 par rapport au substrat 101. À titre d'exemple, la couche électriquement isolante de chaque tranchée 115 est en un matériau diélectrique, par exemple en oxyde de silicium. La couche électriquement isolante de chaque tranchée d'isolation 115 est par exemple en le même matériau que la couche électriquement isolante de la tranchée d'isolation périphérique 111.

La région électriquement conductrice de chaque tranchée d'isolation 115 est par exemple électriquement isolée de la région électriquement conductrice de la tranchée d'isolation périphérique 111. Cela permet par exemple de polariser les régions électriquement conductrices des tranchées d'isolation 115 indépendamment de la région électriquement conductrice de la tranchée d'isolation périphérique 111.

Dans l'exemple représenté, le photosite 100 comporte en outre une même zone 117 de collecte des charges photogénérées dans les première et deuxième zones photosensibles 103 et 107, disposée du côté de la face supérieure 101T du substrat semiconducteur 101 opposée à la première zone photosensible 103. Dans l'orientation de la figure 2B, la zone 117 de collecte de charges s'étend verticalement dans l'épaisseur du substrat 101 depuis sa face supérieure 101T et jusqu'à une profondeur inférieure à celle des tranchées d'isolation 115. La zone 117 de collecte de charges correspond par exemple à une troisième région du substrat 101 dopée du premier type de conductivité, le type N dans cet exemple, et présentant un niveau de dopage N4 compris par exemple entre 1 × 10¹⁶ et 5 × 10²⁰ at./cm³ (dopage N⁺).

Dans cet exemple, le photosite 100 comporte en outre une grille de transfert horizontale 119 adaptée à transférer les charges depuis la deuxième zone photosensible 107 vers la zone 117 de collecte de charges. Plus précisément, un circuit de commande du photosite 100 peut être utilisé pour appliquer alternativement, sur la grille de transfert horizontale 119 :
- un troisième potentiel adapté à bloquer un transfert de charges depuis la deuxième zone photosensible 107 vers la zone de collecte de charges 117 ; ou
- un quatrième potentiel, différent du troisième potentiel, adapté à permettre un transfert de charges depuis la deuxième zone photosensible 107 vers la zone de collecte de charges 117.

Dans l'exemple illustré, la grille de transfert horizontale 119 s'étend horizontalement sur la face supérieure 101T du substrat semiconducteur 101 à l'aplomb de la deuxième zone photosensible 107. La grille de transfert 119 comporte plus précisément une couche 121 électriquement isolante, par exemple en oxyde de silicium, revêtant une partie de la face supérieure 101T du substrat semiconducteur 101 et une couche 123 électriquement conductrice, par exemple en silicium polycristallin dopé, revêtant une face supérieure de la couche 121 électriquement isolante.

Dans l'exemple représenté, le substrat semiconducteur 101 comporte en outre une quatrième région 125 dopée d'un deuxième type de conductivité, le type P dans cet exemple, opposé au premier type de conductivité et présentant un niveau de dopage P1. Dans cet exemple, la quatrième région 125 s'étend verticalement dans l'épaisseur du substrat 101 depuis la face supérieure 101T du substrat 101 et jusqu'à une profondeur inférieure à celle de la zone 117 de collecte de charges. La quatrième région 125 s'étend par exemple horizontalement entre les tranchées d'isolation 115 de la grille de transfert verticale VEGA.

Le substrat 101 comporte par exemple en outre une cinquième région 127 dopée du premier type de conductivité, le type N dans cet exemple, et présentant un niveau de dopage N3. Le niveau de dopage N3 de la cinquième région 127 est par exemple supérieur au niveau de dopage N2 de la deuxième région 109 et inférieur au niveau de dopage N4 de la zone 117. La cinquième région 127 est par exemple située à l'aplomb de la quatrième région 125. Dans cet exemple, la quatrième région 125 du substrat 101 est en contact, par sa face inférieure, avec la face supérieure de la cinquième région 127 sous-jacente. Dans cet exemple, la cinquième région 127 s'étend verticalement dans l'épaisseur du substrat 101 depuis la face inférieure de la quatrième région 125 et jusqu'à une profondeur inférieure à celle de la zone 117 de collecte de charges.

Dans l'exemple représenté, le substrat semiconducteur 101 comporte en outre une sixième région 129 dopée du deuxième type de conductivité, le type P dans cet exemple, et présentant un niveau de dopage P2. Dans cet exemple, la sixième région 129 s'étend verticalement dans l'épaisseur du substrat 101 depuis la face supérieure 101T du substrat 101 et jusqu'à une profondeur supérieure à celle de la zone 117 de collecte de charges et de la cinquième région 127 du substrat 101. La sixième région 129 est par exemple interposée entre les quatrième et cinquième régions 125 et 127, d'une part, et la zone 117 de collecte de charges, d'autre part. En outre, la sixième région 129 peut, comme dans l'exemple illustré en figure 2B, se prolonger horizontalement sous la cinquième région 127 du substrat 101 et sous la zone 117 de collecte de charges. Dans cet exemple, la région 129 s'étend en outre jusqu'à la tranchée d'isolation périphérique 111.

Dans cet exemple, la couche électriquement conductrice 123 et la couche électriquement isolante 121 de la grille de transfert 119 correspondent respectivement à une électrode de grille et à un isolant de grille d'un transistor MTG de transfert des charges photogénérées dans les première et deuxième zones photosensibles 103 et 107, par exemple un transistor MOS (de l'anglais « Metal Oxide Semiconductor », métal oxyde semiconducteur). En outre, les troisième, cinquième et sixième régions 117, 127 et 129 du substrat 101 correspondent respectivement à des régions de drain, de source et de canal du transistor MTG. La quatrième région 125 du substrat 101 permet par exemple de passiver la surface de la cinquième région 127.

À titre d'exemple, les première, deuxième, troisième, quatrième, cinquième et sixième régions 105, 109, 117, 125, 127 et 129 sont formées par implantation ionique dans le substrat semiconducteur 101.

Dans l'exemple représenté, le photosite 100 comporte en outre une autre grille de transfert horizontale 131 adaptée à transférer des charges depuis la deuxième zone photosensible 107 vers un noeud de réinitialisation, non représenté, du photosite 100. La grille de transfert 131 présente par exemple une structure identique ou similaire à celle de la grille de transfert 119 et ne sera pas décrite en détail ci-après. Plus précisément, la grille de transfert 131 fait par exemple partie d'un autre transistor de transfert MTGRST, par exemple un transistor MOS de réinitialisation des zones photosensibles 103 et 107. Le transistor MTGRST de réinitialisation présente par exemple une structure identique ou similaire à celle du transistor de transfert MTG. En particulier, le transistor MTGRST comporte par exemple une zone 132 de collecte de charges identique ou analogue à la zone 117 de collecte de charges du transistor MTG. Dans l'exemple représenté, la deuxième zone de collecte de charges 132 s'étend latéralement sur la face supérieure 101T du substrat 101 à l'aplomb de la deuxième zone photosensible 107.

Dans l'exemple illustré, le photosite 100 comporte en outre des tranchées d'isolation 133 situées de part et d'autre de la deuxième zone photosensible 107. Les tranchées d'isolation 133 s'étendent verticalement dans l'épaisseur du substrat semiconducteur 101, depuis sa face supérieure 101T, jusqu'à une profondeur par exemple inférieure à l'épaisseur de la zone 117 de collecte de charges. Dans cet exemple, les tranchées d'isolation 133 s'étendent en outre horizontalement dans une direction sensiblement perpendiculaire aux plaques formées par les tranchées d'isolation 115 de la grille de transfert verticale VEGA. Dans l'exemple représenté, le fond de chaque tranchée 133 est sur et en contact avec la région 129. À titre d'exemple, les tranchées d'isolation 133 sont des tranchées de type STI (de l'anglais « Shallow Trench Isolation »), ou tranchées peu profondes d'isolation, et présentent par exemple une profondeur de l'ordre de 300 nm.

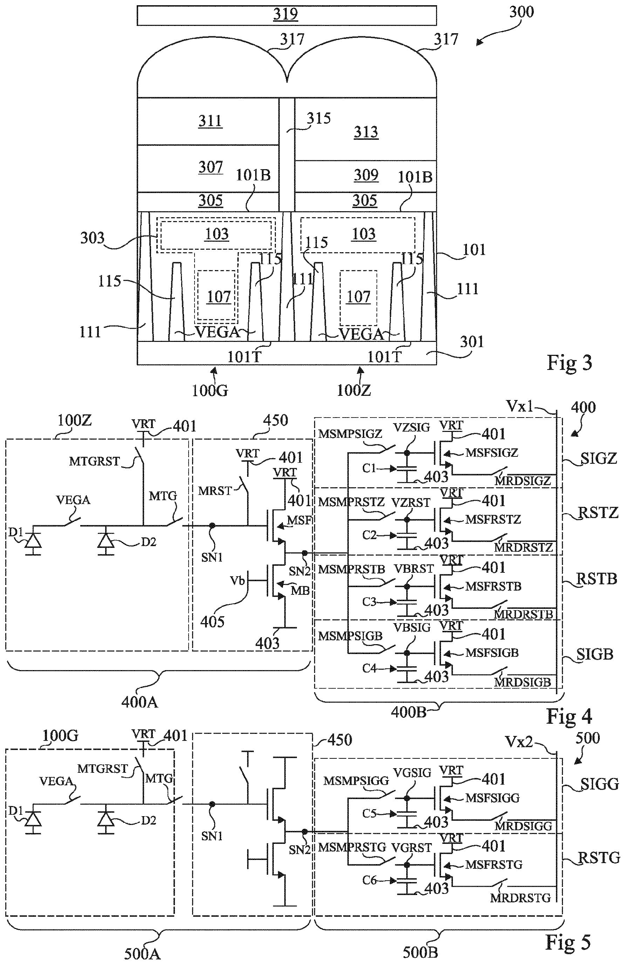

La figure 3 est une vue en coupe, schématique et partielle, d'un capteur d'images 300 comprenant plusieurs photosites du type du photosite 100 de la figure 1 selon un mode de réalisation. La partie du capteur 300 visible en figure 3 comporte plus précisément un photosite 100G adapté à capturer uniquement de la lumière visible, par exemple de la lumière verte, et un photosite 100Z adapté à capter à la fois un rayonnement infrarouge et de la lumière visible, par exemple de la lumière bleue. Les photosites 100G et 100Z de la figure 3 présentent par exemple chacun une structure identique ou similaire à celle du photosite 100 de la figure 1. Bien que seuls deux photosite 100G et 100Z du type du photosite 100 aient été représentés en figure 3, le capteur d'images 300 peut bien évidemment comporter un nombre total de photosites 100G et 100Z beaucoup plus important que celui illustré en figure 3, par exemple plusieurs milliers ou plusieurs millions de photosites 100G et 100Z.

Dans l'exemple représenté, les photosites 100G et 100Z du capteur 300 sont sur et en contact, du côté de leur face 101T (la face inférieure, dans l'orientation de la figure 3), avec un réseau d'interconnexion 301 permettant de commander les photosites 100G et 100Z. Le réseau d'interconnexion 301 comprend par exemple un empilement de niveaux de métallisation séparés les uns des autres par des couches diélectriques. Chaque niveau de métallisation du réseau 301 comporte typiquement plusieurs portions disjointes, isolées électriquement les unes des autres, d'une même couche métallique. Le réseau d'interconnexion 301 peut en outre comporter des vias conducteurs permettant d'interconnecter plusieurs portions de couches métalliques faisant partie de niveaux de métallisation distincts. À des fins de simplification, les niveaux de métallisation, les couches diélectriques et les vias conducteurs n'ont pas été détaillés en figure 3.

Dans l'exemple du capteur d'images 300, la première zone photosensible 103 du photosite 100Z est adaptée à capter de la lumière visible, par exemple de la lumière bleue, et la deuxième zone photosensible 107 du photosite 100Z est adaptée à capter un rayonnement infrarouge, par exemple un rayonnement infrarouge proche.

Dans cet exemple, les zones photosensibles 103 et 107 du photosite 100G sont toutes les deux adaptées à capter de la lumière visible, par exemple de la lumière verte. À titre d'exemple, la grille de transfert verticale VEGA du photosite 100G peut être en permanence commandée à l'état passant. Dans ce cas, les première et deuxième zones photosensibles 103 et 107 du photosite 100G sont par exemple réunies, ou mutualisées, formant ainsi une unique zone photosensible 303.

Dans l'exemple représenté, chaque photosite 100G, 100Z est revêtu, du côté de sa face 101B (la face supérieure, dans l'orientation de la figure 3), d'une couche 305 anti-reflet et de passivation.

Dans cet exemple, la couche 305 du photosite 100G est revêtue d'une couche 307 de résine. À titre d'exemple, la couche de résine 307 agit comme un filtre couleur adapté à ne laisser passer que de la lumière verte, par exemple dans la plage de longueurs d'onde de 510 à 570 nm. En outre, la couche 305 du photosite 100Z est revêtue d'une couche 309 de résine différente de la couche 307. À titre d'exemple, la couche de résine 309 agit comme un filtre couleur adapté à ne laisser passer que de la lumière bleue, par exemple dans la plage de longueurs d'onde de 430 à 490 nm.

Dans l'exemple représenté, la couche de résine 307 du photosite 100G est revêtue d'une autre couche 311 de résine. À titre d'exemple, la couche de résine 311 agit comme un filtre adapté à laisser passer de la lumière visible, par exemple dans la plage de longueurs d'onde de 400 à 700 nm, la couche 311 étant par exemple opaque à une gamme ou bande de longueurs d'onde centrée sur environ 940 nm. En outre, la couche de résine 309 du photosite 100Z est revêtue d'une couche 313 de résine. La couche 313 est par exemple transparente à la lumière visible et aux rayonnements infrarouges et permet de compenser une différence de hauteur entre la couche 309 du photosite 100Z et la couche 311 du photosite 100G.

Dans l'exemple représenté, les couches 305, 307 et 311 du photosite 100G sont séparées des couches 305, 309 et 313 du photosite 100Z par une barrière verticale 315 d'isolation optique. La barrière verticale 315 permet par exemple d'éviter les phénomènes de diaphotie (« optical cross-talk », en anglais) entre les différents photosites 100G, 100Z du capteur 300.

Dans cet exemple, chaque photosite 100G, 100Z est en outre surmonté d'une microlentille 317.

La couche 313 est par exemple en le même matériau que les microlentilles 317. À titre de variante, la couche 313 est en dioxyde de silicium (SiO₂).

Comme illustré en figure 3, un filtre double-bande 319 peut être disposé au-dessus des microlentilles 317. Le filtre 319 est par exemple adapté à ne laisser passer que la lumière visible et un rayonnement infrarouge présentant une longueur d'onde égale à environ 940 nm.

Pour l'acquisition d'images 2D couleur, les photosites du capteur d'images 300 sont par exemple répartis en groupes élémentaires de quatre photosites, chaque groupe comprenant plus précisément un photosite 100Z adapté à capter de la lumière bleue et un rayonnement infrarouge, appelé photosite bleu et de profondeur, deux photosites 100G adaptés à capter uniquement de la lumière verte, appelés photosites verts, et un photosite adapté à capter uniquement de la lumière rouge, appelé photosite rouge. Le photosite rouge présente par exemple une structure analogue à celle précédemment décrite pour le photosite vert 100G. Plus précisément, le photosite rouge diffère par exemple du photosite vert 100G en ce que la couche de résine 307 du photosite rouge est adaptée à ne laisser passer que de la lumière rouge, par exemple dans la plage de longueurs d'onde de 620 à 700 nm. À titre d'exemple, les photosites du capteur d'images 300 sont arrangés selon une matrice de Bayer.

Le capteur d'images 300 est par exemple adapté à acquérir, outre des images 2D couleur d'une scène, des images de profondeur de la scène. Les images de profondeur sont par exemple acquises par le capteur d'images 300 en mettant en oeuvre une mesure de distance par de temps de vol indirect (« indirect Time of Flight » - iToF, en anglais). Pour cela, un rayonnement, ou signal, infrarouge incident modulé en amplitude à une fréquence de modulation Fmod est par exemple émis par une source en direction de la scène. Le rayonnement, ou signal, réfléchi par la scène, présentant par rapport au rayonnement incident un déphasage Δϕ, est capturé par les photosites 100Z du capteur d'images 300. Pour chaque photosite, le déphasage Δϕ du rayonnement capturé par le photosite est fonction de la distance entre le dispositif et un point ou une région de la scène vue par le photosite.

À titre d'exemple, pour chaque pixel d'une image de profondeur à acquérir par le capteur d'images 300, un groupe de quatre photosites 100Z voisins est utilisé pour échantillonner le signal réfléchi par la scène, afin d'estimer le déphasage Δϕ (module 2π). Plus précisément, les quatre photosites 100Z sont par exemple configurés pour acquérir, durant chaque période de modulation (fréquence Fmod) du signal réfléchi, quatre échantillons successifs correspondant chacun à une quantité de charges photogénérées dans la deuxième zone photosensible 107 du photosite 100Z pendant une durée égale environ à un quart de la période du signal réfléchi, puis transférées vers une zone de stockage. Ces quatre échantillons sont cumulés ou intégrés sur plusieurs périodes du signal réfléchi, par exemple sur plusieurs milliers ou millions de périodes, et permettent de remonter au déphasage Δϕ entre l'onde incidente et l'onde réfléchie.

À titre de variante, on peut prévoir d'utiliser, pour chaque pixel de l'image de profondeur à acquérir, seulement trois photosites 100Z voisins. Dans ce cas, les trois photosites 100Z sont par exemple configurés pour acquérir, durant chaque période du signal réfléchi, trois échantillons successifs correspondant chacun à une quantité de charges photogénérées pendant des fenêtres d'échantillonnage égales chacune à environ un tiers de la période du signal réfléchi.

À titre de variante, on peut prévoir d'utiliser par exemple deux photosites 100Z pour acquérir les quatre échantillons, chacun des deux photosites 100Z adaptés à former un même pixel de l'image de profondeur étant par exemple utilisé pour acquérir deux sous-images successives. Plus précisément, les deux photosites 100Z sont par exemple configurés pour acquérir, lors d'une première phase d'acquisition, les échantillons correspondant à des premier et deuxième quarts de la période de modulation du signal lumineux, et, lors d'une deuxième phase d'acquisition, les échantillons correspondant à des troisième et quatrième quarts de la période de modulation du signal lumineux. La combinaison des deux sous-images permet d'obtenir les quatre échantillons à partir desquels le déphasage Δϕ est calculé pour former l'image de profondeur.

L'acquisition de plusieurs échantillons par un même photosite permet avantageusement d'augmenter la résolution du capteur. À titre d'exemple, par rapport à un cas où chaque photosite est configuré pour acquérir un seul échantillon, on peut augmenter la résolution du capteur en prévoyant que chaque photosite soit configuré pour acquérir deux ou trois échantillons, chaque pixel de l'image de profondeur étant obtenu au moyen de deux photosites ou d'un seul photosite, respectivement. En outre, l'acquisition de plusieurs échantillons par un même photosite permet avantageusement d'augmenter la cadence de prise de vue. À titre d'exemple, dans un cas où deux photosites sont utilisés pour reconstituer chaque pixel de l'image de profondeur, deux images sont utilisées pour calculer la distance si chaque photosite capture un seul échantillon tandis qu'une seule image est utilisée pour calculer la distance si chaque photosite capture deux échantillons. Toutefois, le fait d'acquérir plusieurs échantillons par un même photosite tend à augmenter les dimensions du photosite.

La figure 4 est un schéma électrique d'un circuit de commande 400 du photosite 100 de la figure 1 selon un mode de réalisation. Le circuit 400 est par exemple plus précisément utilisé dans le cas où le photosite 100 est mis en oeuvre en tant que photosite 100Z adapté à capter de la lumière bleue et un rayonnement infrarouge.

Dans l'exemple illustré en figure 4, le circuit de commande 400 comprend un premier niveau 400A, dédié à la collecte des charges photogénérées dans les première et deuxième zones photosensibles 103 et 107 du photosite 100Z, et un deuxième niveau 400B, dédié au stockage et à la lecture des charges provenant du premier niveau 400A.

Dans le premier niveau 400A du circuit 400, la grille de transfert verticale VEGA relie la cathode de la première photodiode pincée D1 à la cathode de la deuxième photodiode pincée D2. La grille de transfert verticale VEGA permet de transférer des charges photogénérées dans la photodiode D1 vers la photodiode D2. En outre, dans cet exemple, le transistor de transfert MTGRST, symbolisé en figure 4 par un commutateur, relie la cathode de la deuxième diode pincée D2 à un noeud 401 d'application d'un potentiel VRT d'alimentation du photosite 100Z. Le potentiel VRT est par exemple utilisé comme potentiel de réinitialisation. Le transistor de transfert MTG, symbolisé en figure 4 par un commutateur, relie la cathode de la diode D2 à un premier noeud SN1 de stockage de charges. Le transistor MTG permet le transfert des charges depuis la photodiode D2 vers le noeud SN1. Le noeud SN1 est par exemple connecté à la zone 117 de collecte de charges photogénérées dans les première et deuxième zones photosensibles 103 et 107. Dans l'exemple représenté, le noeud SN1 fait partie d'un circuit 450 de recopie, ou report, du potentiel présent au noeud SN1 sur un autre noeud SN2 de stockage de charges.

Dans cet exemple, le circuit 450 comporte un commutateur MRST, par exemple un transistor MOS, reliant le noeud SN1 au noeud 401 d'application du potentiel d'alimentation VRT. Le commutateur MRST permet par exemple de réinitialiser le noeud SN1 en lui appliquant le potentiel VRT. Dans l'exemple illustré en figure 4, le noeud SN1 est connecté à une électrode de grille d'un transistor MSF du circuit 450, par exemple un transistor MOS, dont les électrodes de drain et de source sont respectivement connectées au noeud 401 d'application du potentiel VRT et au deuxième noeud SN2 de stockage de charges. Le transistor MSF, monté en suiveur de tension, permet par exemple de recopier, sur le noeud SN2, la tension présente au noeud SN1, à une tension grille-source près. En outre, dans cet exemple, le noeud SN2 est connecté à une électrode de drain d'un autre transistor MB du circuit 450, par exemple un transistor MOS, dont les électrodes de source et de grille sont respectivement connectées à un noeud 403 d'application d'un potentiel de référence, par exemple la masse, et à un noeud 405 d'application d'un potentiel Vb, par exemple associé à une tension de polarisation commune du circuit 400. Le transistor MB est, dans cet exemple, monté en source de courant et permet d'alimenter le transistor MSF par un courant constant.

Dans l'exemple représenté, le deuxième niveau 400B du circuit 400 comporte quatre branches SIGZ, RSTZ, RSTB et SIGB reliant chacune le noeud SN2 du circuit 450 à une colonne Vx1. La colonne Vx1 est par exemple connectée à un circuit de lecture, non représenté en figure 4, situé en pied de colonne.

Dans cet exemple, les branches SIGZ, RSTZ, RSTB, SIGB comportent respectivement :
- un premier commutateur MSMPSIGZ, MSMPRSTZ, MSMPRSTB, MSMPSIGB reliant le noeud SN2 à un noeud VZSIG, VZRST, VBRST, VBSIG ;
- un élément capacitif C1, C2, C3, C4 comprenant une première borne connectée au noeud VZSIG, VZRST, VBRST, VBSIG et une deuxième borne connectée au noeud 403 d'application du potentiel de référence ;
- un transistor MSFSIGZ, MSFRSTZ, MSFRSTB, MSFSIGB comprenant une borne de grille connectée au noeud VZSIG, VZRST, VBRST, VBSIG et une borne de drain connectée au noeud 401 d'application du potentiel VRT ; et
- un deuxième commutateur MRDSIGZ, MRDRSTZ, MRDRSTB, MRDSIGB reliant une borne de source du transistor MSFSIGZ, MSFRSTZ, MSFRSTB, MSFSIGB à la colonne Vx1.

À titre d'exemple, les commutateurs et les transistors des branches SIGZ, RSTZ, RSTB et SIGB du circuit 400 sont des transistors MOS.

Dans cet exemple, les commutateurs MSMPSIGZ, MSMPRSTZ, MSMPRSTB, MSMPSIGB sont utilisés comme interrupteurs de multiplexage entre le noeud SN2 et l'élément capacitif C1, C2, C3, C4 correspondant, en permettant par exemple un accès en écriture à ces éléments capacitifs. Les transistors MOS MSFSIGZ, MSFRSTZ, MSFRSTB, MSFSIGB sont montés en suiveurs de tension et sont par exemple utilisés pour recopier sur leur source, à une tension grille-source près, la tension stockée par l'élément capacitif C1, C2, C3, C4 correspondant. Les commutateurs MRDSIGZ, MRDRSTZ, MRDRSTB, MRDSIGB sont utilisés comme interrupteurs de connexion à la colonne Vx1 et permettent d'appliquer, sur la colonne Vx1, la tension de source du transistor MSFSIGZ, MSFRSTZ, MSFRSTB, MSFSIGB correspondant.

Le circuit de commande 400 permet avantageusement d'intégrer simultanément des charges photogénérées dans les zones photosensibles 103 et 107 des photodiodes D1 et D2, d'échantillonner les charges photogénérées dans la photodiode D2 en parallèle de l'intégration dans les photodiodes D1 et D2 et de lire successivement, via un même chemin électrique, des signaux permettant de reconstituer une image de profondeur et une image 2D d'une scène.

Dans l'exemple illustré en figure 4, le circuit de commande 400 est compatible avec un fonctionnement du capteur d'images en mode dit à obturateur global (« global shutter », en anglais). Toutefois, la personne du métier est capable d'adapter le circuit 400 pour le rendre compatible avec un fonctionnement du capteur d'images en mode dit à obturateur déroulant (« rolling shutter », en anglais).

La figure 5 est un schéma électrique d'un circuit de commande 500 du photosite 100 de la figure 1 selon un autre mode de réalisation. Le circuit 500 de la figure 5 comprend des éléments en commun avec le circuit 400 de la figure 4. Ces éléments communs ne seront pas décrits à nouveau en détail ci-après. Le circuit 500 est par exemple plus précisément utilisé dans le cas où le photosite 100 est mis en oeuvre en tant que photosite 100G adapté à capter de la lumière verte.

Dans l'exemple représenté, le circuit 500 comprend un premier niveau 500A identique au premier niveau 400A du circuit 400. Dans cet exemple, le circuit 500 comprend en outre un deuxième niveau 500B. Le deuxième niveau 500B du circuit 500 diffère par exemple du deuxième niveau 400B du circuit 400 en ce que le deuxième niveau 500B du circuit 500 comporte seulement deux branches SIGG et RSTG reliant chacune le noeud SN2 du circuit 450 à une colonne Vx2, par exemple différente de la colonne Vx1. Les branches SIGG et RSTG du circuit 500 présentent par exemple des structures similaires à celles des branches SIGB et RSTB, respectivement, du circuit 400 de la figure 4.

Plus précisément, dans cet exemple, les branches SIGG et RSTG comportent respectivement :
- un premier commutateur MSMPSIGG, MSMPRSTG reliant le noeud SN2 à un noeud VGSIG, VGRST ;
- un élément capacitif C5, C6 comprenant une première borne connectée au noeud VGSIG, VGRST et une deuxième borne connectée au noeud 403 d'application du potentiel de référence ;
- un transistor MSFSIGG, MSFRSTG comprenant une borne de grille connectée au noeud VGSIG, VGRST et une borne de drain connectée au noeud 401 d'application du potentiel VRT ; et
- un deuxième commutateur MRDSIGG, MRDRSTG reliant une borne de source du transistor MSFSIGG, MSFRSTG à la colonne Vx2.

À titre d'exemple, les commutateurs et les transistors des branches SIGG et RSTG du circuit 500 sont des transistors MOS.

Les transistors MSMPSIGG, MSMPRSTG, MSFSIGG, MSFRSTG, MRDSIGG et MRDRSTG présentent par exemple des fonctions analogues à celles précédemment exposées pour les transistors MSMPSIGB, MSMPRSTB, MSFSIGB, MSFRSTB, MRDSIGB et MRDRSTB, respectivement.

Bien que l'on ait exposé ci-dessus en relation avec la figure 5 un mode de réalisation dans lequel le circuit 500 est utilisé pour commander un photosite 100G adapté à capter de la lumière verte, la personne du métier est capable d'adapter le circuit 500 pour commander un photosite adapté à capter de la lumière rouge. Plus précisément, un circuit identique au circuit 500 pourrait être utilisé.

Dans un souci de simplification, on a exposé ci-dessus en relation avec les figures 4 et 5 des circuits de commande 400 et 500 utilisant une même tension d'alimentation VRT sur chaque branche SIGZ, RSTZ, SIGB, RSTB, SIGG et RSTG. À titre de variante, on pourrait prévoir d'utiliser des tensions d'alimentation différentes sur toutes ou partie de ces branches.

En outre, on a exposé ci-dessus en relation avec les figures 4 et 5 des circuits 400 et 500 dont les deuxièmes niveaux 400B et 500B comportent, pour chaque capacité C1, C2, C3, C4, C5, C6, un transistor MSFSIGZ, MSFRSTZ, MSFRSTB, MSFSIGB, MSFSIGG, MSFRSTG dont la grille est connectée à l'une des bornes de la capacité correspondante et dont la source est reliée à la colonne Vx1, Vx2 correspondante par un commutateur MRDSIGZ, MRDRSTZ, MRDRSTB, MRDSIGB, MRDSIGG, MRDRSTG. À titre de variante, on peut prévoir que toutes les capacités d'un même deuxième niveau 400B, 500B soient reliées, par des commutateurs, à la grille d'un seul transistor de lecture dont la source est reliée, par un autre transistor, à la colonne Vx1, Vx2 correspondante, et que le potentiel appliqué sur la grille du transistor de lecture soit réinitialisé au moyen d'encore un autre transistor. La mise en oeuvre de cette variante est à la portée de la personne du métier à partir des indications de la présente description.

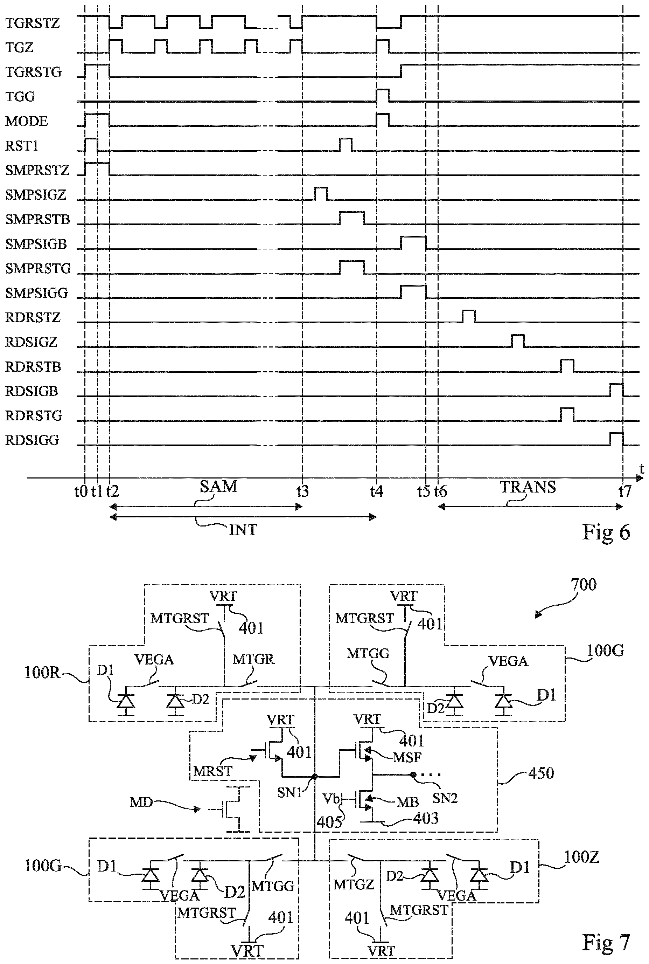

La figure 6 est un chronogramme illustrant un mode de mise en oeuvre d'un procédé de commande des photosites 100Z et 100G du capteur d'images 300 de la figure 3 respectivement commandés par les circuits 400 et 500 des figures 4 et 5.

Plus précisément, la figure 6 illustre l'évolution, en fonction du temps t :
- d'un signal TGRSTZ de commande du transistor de transfert MTGRST du photosite 100Z ;
- d'un signal TGZ de commande du transistor de transfert MTG du photosite 100Z ;
- d'un signal TGRSTG de commande du transistor de transfert MTGRST du photosite 100G ;
- d'un signal TGG de commande du transistor de transfert MTG du photosite 100G ;
- d'un signal MODE de commande des grilles de transfert verticales VEGA des photosites 100Z et 100G ou, à titre de variante, de la grille de transfert verticale VEGA du photosite 100Z uniquement ;
- d'un signal RST1 de commande des commutateurs MRST des photosites 100Z et 100G ;
- d'un signal SMPRSTZ de commande du commutateur MSMPRSTZ de la branche RSTZ du deuxième niveau 400B du circuit 400 ;
- d'un signal SMPSIGZ de commande du commutateur MSMPSIGZ de la branche SIGZ du deuxième niveau 400B du circuit 400 ;
- d'un signal SMPRSTB de commande du commutateur MSMPRSTB de la branche RSTB du deuxième niveau 400B du circuit 400 ;
- d'un signal SMPSIGB de commande du commutateur MSMPSIGB de la branche SIGB du deuxième niveau 400B du circuit 400 ;
- d'un signal SMPRSTG de commande du commutateur MSMPRSTG de la branche RSTG du deuxième niveau 500B du circuit 500 ;
- d'un signal SMPSIGG de commande du commutateur MSMPSIGG de la branche SIGG du deuxième niveau 500B du circuit 500 ;
- d'un signal RDRSTZ de commande du commutateur MRDRSTZ de la branche RSTZ du deuxième niveau 400B du circuit 400 ;
- d'un signal RDSIGZ de commande du commutateur MRDSIGZ de la branche SIGZ du deuxième niveau 400B du circuit 400 ;
- d'un signal RDRSTB de commande du commutateur MRDRSTB de la branche RSTB du deuxième niveau 400B du circuit 400 ;
- d'un signal RDSIGB de commande du commutateur MRDSIGB de la branche SIGB du deuxième niveau 400B du circuit 400 ;
- d'un signal RDRSTG de commande du commutateur MRDRSTG de la branche RSTG du deuxième niveau 500B du circuit 500 ; et
- d'un signal RDSIGG de commande du commutateur MRDSIGG de la branche SIGG du deuxième niveau 500B du circuit 500.

Dans le procédé illustré en figure 6, chaque signal de commande présente des états haut et bas. Dans cet exemple, le commutateur est fermé, ou le transistor est passant, lorsque le signal de commande correspondant est à l'état haut et le commutateur est ouvert, ou le transistor est bloqué, lorsque le signal de commande correspondant est à l'état bas. Cet exemple n'est toutefois pas limitatif, la personne du métier étant en mesure d'adapter ce qui est décrit en relation avec la figure 6 au cas où le commutateur est fermé lorsque le signal de commande correspondant est à l'état bas et ouvert lorsque le signal de commande correspondant est à l'état haut.

Entre un instant t0 et un autre instant t1, postérieur à l'instant t0, les signaux TGRSTZ, TGRSTG, MODE, RST1 et SMPRSTZ sont à l'état haut. Dans chaque photosite 100G, 100Z, on évacue ainsi les charges de la photodiode D1 en les transférant vers la photodiode D2 et on évacue les charges de la photodiode D2 en les transférant vers le noeud 401 d'application du potentiel d'alimentation VRT via le commutateur MTGRST. En outre, le noeud SN1 de chaque photosite 100G, 100Z est réinitialisé par application du potentiel VRT via le commutateur MRST. Dans le photosite 100G, 100Z, le potentiel présent au noeud SN1 après réinitialisation est écrit dans la capacité de stockage C2 via le transistor MSMPRSTZ. Dans cet exemple, tous les autres commutateurs sont à l'état ouvert entre les instants t0 et t1.

À l'instant t1, le signal RST1 de commande des commutateurs MRST des photosites 100G et 100Z est commuté vers l'état bas, les signaux TGRSTZ, TGRSTG, MODE et SMPRSTZ étant maintenus à l'état haut. Cela a pour effet d'ouvrir les commutateurs MRST et de mémoriser le potentiel VRT aux noeuds SN1 des photosites 100G et 100Z.

À un instant t2, postérieur à l'instant t1, les signaux TGRSTZ, TGRSTG, MODE et SMPRSTZ sont commutés vers l'état bas. Entre l'instant t2 et un instant t3, postérieur à l'instant t2, on effectue une phase d'échantillonnage SAM des charges photogénérées dans la photodiode D2 du photosite 100Z. Plus précisément, les charges photogénérées dans la photodiode D2 du photosite 100Z sont transférées périodiquement vers le noeud SN1 en commandant le transistor de transfert MTG du photosite 100Z à l'état passant puis à l'état bloqué de façon périodique. La diode D2 est réinitialisée périodiquement en commandant le transistor de transfert MTGRST du photosite 100Z à l'état passant puis à l'état bloqué pendant les phases où le transistor MTG est à l'état bloqué.

Dans l'exemple représenté, le signal TGRSTZ présente un rapport cyclique égal à environ 3/4 et le signal TGZ présente un rapport cyclique égal à environ 1/4. Trois autres photosites du capteur d'image 300, par exemple des photosites 100Z voisins du photosite 100Z considéré, présentant des signaux TGRSTZ et TGZ déphasés de π/2, π et 3π/2 par rapport aux signaux TGRSTZ et TGZ illustrés en figure 6 peuvent être utilisés pour échantillonner le rayonnement infrarouge et remonter à la valeur du déphasage Δϕ. À titre de variante, on pourrait prévoir des signaux TGRSTZ et TGZ présentant des rapports cycliques respectivement égaux à environ 2/3 et 1/3. Dans ce cas, deux autres photosites présentant des signaux TGRSTZ et TGZ déphasés chacun de 2π/3 et 4π/3 par rapport aux signaux TGRSTZ et TGZ du photosite 100Z, par exemple des photosites 100Z voisins du photosite 100Z considéré, peuvent être utilisés pour échantillonner le rayonnement infrarouge.

À l'instant t2 débute également une phase d'intégration INT dans la photodiode D1 du photosite 100Z et dans les photodiodes D1 et D2 du photosite 100G. La phase d'intégration INT s'achève à un instant t4, postérieur à l'instant t3. À l'instant t3, le signal TGRSTZ est commuté vers l'état haut et le signal TGZ est commuté vers l'état bas. On évacue ainsi, vers le noeud 401 d'application du potentiel VRT, des charges continuant d'être photogénérées dans la photodiode D2 sous l'effet de l'absorption du rayonnement infrarouge et/ou des charges résiduelles pouvant subsister dans la photodiode D2. Entre les instants t3 et t4, on commute d'abord le signal SMPSIGZ vers l'état haut puis vers l'état bas. Cela a pour effet de stocker, dans la capacité C1, la tension présente au noeud SN1 (à une tension grille-source près) obtenue suite à l'accumulation des charges sur ce noeud durant la phase d'échantillonnage SAM. On commute ensuite simultanément les signaux RST1, SMPRSTB et SMPRSTG vers l'état haut, puis on commute le signal RST1 vers l'état bas et enfin on commute les signaux SMPRSTB et SMPRSTG vers l'état bas. Cela permet de préparer la lecture des charges photogénérées par la lumière visible en procédant à la réinitialisation des noeuds SN1 des photosites 100Z et 100G pour que ceux-ci puissent ultérieurement recevoir les charges photogénérées dans la photodiode D1 du photosite 100Z et dans les photodiodes D1 et D2 du photosite 100G. Les potentiels de réinitialisation appliqués aux noeuds SN1 des photosites 100Z et 100G sont mémorisés dans les capacités C3 et C6, respectivement.

Entre l'instant t4 et un instant t5, postérieur à l'instant t4, les signaux TGZ, TGG et MODE sont simultanément commutés vers l'état haut, puis simultanément commutés vers l'état bas. Les charges stockées dans les photodiodes D1 des photosites 100Z et 100G sont ainsi transférées dans la photodiode D2. Dans le cas du photosite 100Z, la photodiode D2 a préalablement été vidée de ses charges photogénérées par le rayonnement infrarouge. Dans le cas du photosite 100G, les charges photogénérées dans la photodiode D1 s'ajoutent aux charges photogénérées dans la photodiode D2. Les charges se trouvant dans la photodiode D2 de chaque photosite 100Z, 100G sont en outre transférées au noeud SN1. Les signaux TGRSTZ et TGRSTG sont maintenus à l'état bas durant ces opérations.

Les signaux SMPSIGB et SMPSIGG sont ensuite simultanément commutés vers l'état haut, puis simultanément commutés vers l'état bas pour écrire et stocker, dans les capacités C4 et C5, les tensions des noeuds SN1 (à une tension grille-source près) des photosites 100Z et 100G, obtenues suite aux transferts des charges sur ces noeuds. En outre, les signaux TGRSTZ et TGRSTG des photosites 100Z et 100G sont simultanément commutés vers l'état haut pour réinitialiser les photodiodes D2 en évacuant des charges photogénérées supplémentaires, susceptibles de remplir la photodiode D2. Les signaux SMPSIGB et SMPSIGG sont ensuite commutés vers l'état bas, tandis que les signaux TGRSTZ et TGRSTG sont maintenus à l'état haut.

Dans l'exemple représenté, entre un instant t6, postérieur à l'instant t5, et un instant t7, postérieur à l'instant t6, on effectue une phase de lecture TRANS durant laquelle les opérations suivantes sont successivement exécutées :
- le signal RDRSTZ est commuté vers l'état haut puis vers l'état bas, pour recopier la tension présente aux bornes de la capacité C2 sur la colonne Vx1 (à une tension grille-source près) ;
- le signal RDSIGZ est commuté vers l'état haut puis vers l'état bas, pour recopier la tension présente aux bornes de la capacité C1 sur la colonne Vx1 (à une tension grille-source près) ;
- les signaux RDRSTB, RDRSTG sont simultanément commutés vers l'état haut, puis simultanément commutés vers l'état bas, pour recopier les tensions présentes respectivement aux bornes des capacités C3, C5 sur les colonnes Vx1, Vx2 (à une tension grille-source près) ; et
- les signaux RDSIGB, RDSIGG sont simultanément commutés vers l'état haut, puis simultanément commutés vers l'état bas, pour recopier les tensions présentes respectivement aux bornes des capacités C4, C6 sur les colonnes Vx1, Vx2 (à une tension grille-source près).

Dans cet exemple, les capacités reliées à une même colonne Vx1, Vx2 sont lues successivement tandis que les capacités reliées à des colonnes Vx1, Vx2 différentes sont lues simultanément. Après chaque recopie sur l'une des colonnes Vx1, Vx2, les tensions sont par exemple stockées en pied de colonne par des circuits de lecture.

La figure 7 est un schéma électrique d'un circuit 700 de commande de quatre photosites du type du photosite 100 de la figure 1 selon un mode de réalisation.

En figure 7, on a plus précisément représenté un photosite 100R, adapté à capter majoritairement de la lumière rouge, deux photosites 100G, adaptés à capter majoritairement de la lumière verte, et un photosite 100Z adapté à capter majoritairement de la lumière bleue et un rayonnement infrarouge. Les photosites 100R, 100G et 100Z sont par exemple identiques ou similaires au photosite 100. Dans cet exemple, les photosites 100R, 100G, 100Z comportent respectivement des transistors de transfert MTGR, MTGG, MTGZ analogues au transistor de transfert MTG du photosite 100. En figure 7, les transistors MTGR, MTGB et MTGZ sont symbolisés chacun par un commutateur dont une borne est connectée à la cathode de la photodiode D2 et dont une autre borne est connectée au noeud SN1 du circuit 450 précédemment décrit en relation avec la figure 4.

Plus précisément, le noeud SN1 est connecté à la borne de source du transistor MRST et à la borne de grille du transistor MSF. Les bornes de drain des transistors MRST et MSF sont connectées chacune au noeud 401 d'application du potentiel VRT. En outre, la borne de source du transistor MSF est connectée à la borne de drain du transistor MB, la borne de source du transistor MB étant connectée au noeud 403.

Les transistors MRST, MSF et MB sont par exemple répartis dans les circuits de commande des photosites 100R, 100G et 100Z. Plus précisément, dans l'exemple représenté, le transistor MRST fait partie du circuit de commande du photosite 100R, le transistor MSF fait partie du circuit de commande de l'un des photosites 100G et le transistor MB fait partie du circuit de commande du photosite 100Z. À titre d'exemple, le circuit de commande de l'autre photosite 100G peut comporter un transistor MD non utilisé (« dummy », en anglais). Cela permet par exemple de prévoir des circuits de commande identiques ou similaires pour tous les photosites 100R, 100G et 100Z du capteur. La réalisation du capteur d'images est ainsi facilitée.

Un avantage du circuit de commande 700 illustré en figure 7 tient au fait qu'il permet de mettre en oeuvre une architecture de photosite à quatre transistors, dite « 4T », au lieu d'une architecture de photosite à six transistors, dite « 6T ». Il en résulte un gain d'espace et de coût.

Bien que cela n'ait pas été illustré en figure 7, le noeud SN2 du circuit 450 peut être connecté à un niveau identique ou similaire au deuxième niveau 400B du circuit 400 précédemment décrit en relation avec la figure 4. La personne du métier est capable de déduire le fonctionnement du circuit de commande 700 de la figure 7 à partir des indications fournies ci-dessus en relation avec les figures 4 et 6.

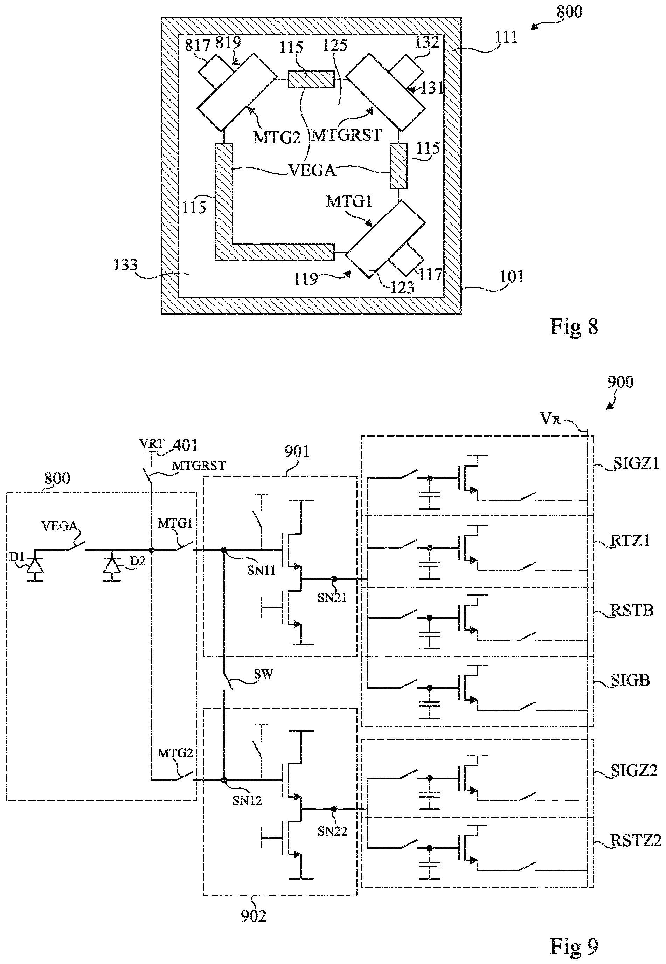

La figure 8 est une vue de dessus, schématique et partielle, d'un photosite 800 de capteur d'images selon un autre mode de réalisation. Le photosite 800 de la figure 8 comprend des éléments communs avec le photosite 100 de la figure 1. Ces éléments communs ne seront pas décrits à nouveau ci-après. Le photosite 800 de la figure 8 diffère du photosite 100 de la figure 1 en ce que le photosite 800 comporte, outre le transistor de transfert MTGRST, deux autres transistors de transfert MTG1 et MTG2 identiques ou similaires au transistor de transfert MTG du photosite 100.

Plus précisément, dans l'exemple représenté, le transistor MTG2 comporte une zone 817 de collecte de charges photogénérées dans la deuxième zone photosensible 107 et une grille de transfert 819 horizontale identiques ou similaires, respectivement, à la zone 117 et à la grille 119 du transistor MTG1.

Afin d'optimiser l'espace disponible, les transistors MTG1, MTG2 et MTGRST sont par exemple, comme illustré en figure 8, disposés dans trois coins du carré formé par la tranchée d'isolation périphérique 111 du photosite 800. Dans cet exemple, la grille de transfert verticale VEGA comporte trois tranchées d'isolation 115 disjointes s'étendant latéralement entre les grilles des transistors MTG1, MTG2 et MTGRST. La géométrie du photosite 800 illustrée en figure 8 n'est pas limitative, la personne du métier pouvant prévoir toute géométrie adaptée à l'intégration de trois transistors de transfert à l'intérieur d'un même photosite.

Un avantage du photosite 800 tient au fait qu'il permet de capturer deux échantillons du signal lumineux infrarouge reçu au moyen d'une même image de profondeur. Cela permet de gagner encore davantage en résolution, ou en nombre d'images utiles pour la capture de la totalité des échantillons, par rapport au photosite 100.

La figure 9 est un schéma électrique d'un circuit 900 de commande du photosite 800 de la figure 8 selon un mode de réalisation.

Dans l'exemple représenté, le circuit 900 comprend deux circuits 901 et 902, par exemple identiques ou similaires chacun au circuit 450 du circuit 400 de la figure 4. Plus précisément, dans cet exemple, chaque circuit 901, 902 comporte un noeud SN11, SN12 analogue au noeud SN1 du circuit 450 de la figure 4 et un autre noeud SN21, SN22 analogue au noeud SN2 du circuit 450. Dans l'exemple illustré en figure 9, les noeuds SN11 et SN12 des circuits 901 et 902 sont respectivement connectés aux transistors de transfert MTG1 et MTG2 du photosite 800, par exemple aux zones 117 et 817 du photosite 800.

Dans cet exemple, le circuit 900 comprend en outre des branches SIGZ1, RSTZ1, RSTB et SIGB reliant le noeud SN21 du circuit 901 à une colonne Vx et des branches SIGZ2 et RSTZ2 reliant le noeud SN22 à la colonne Vx. Les branches SIGZ1 et SIGZ2 du circuit 900 sont par exemple identiques ou similaires à la branche SIGZ du circuit 400 de la figure 4 et les branches RSTZ1 et RSTZ2 du circuit 900 sont par exemple identiques ou similaires à la branche RSTZ du circuit 400. En outre, les branches RSTB et SIGB du circuit 900 sont par exemple identiques aux branches RSTB et SIGB du circuit 400.

La personne du métier est capable de déduire le fonctionnement du circuit de commande 900 de la figure 9 à partir du fonctionnement du circuit de commande 400 de la figure 4 précédemment décrit en relation avec les figures 4 et 6. En particulier, lors de la phase d'échantillonnage, les transistors de transfert MTG1 et MTG2 sont commandés de sorte que chaque transistor MTG1, MTG2 est passant pendant un quart de la période du signal. Pendant la moitié restante de la période du signal, le transistor MTGRST est passant tandis que MTG1 et MTG2 sont bloqués. Cela permet avantageusement d'acquérir deux échantillons par photosite 800 au moyen d'une même image de profondeur.

De façon optionnelle, le circuit 900 peut en outre comporter un commutateur SW, par exemple un transistor MOS, reliant le noeud SN11 du circuit 901 au noeud SN12 du circuit 902. Le commutateur SW relie par exemple le transistor MTG1 au transistor MTG2, le commutateur comportant par exemple plus précisément une borne connectée à la zone 117 et une autre borne connectée à la zone 817 du photosite 800. Dans ce cas, lorsque le transistor MTG1 est à l'état passant pour transférer les charges photogénérées dans la zone photosensible 103, dans le cas du photosite 100Z, ou dans les zones photosensibles 103 et 107, dans le cas des photosites 100G et 100R, à l'issue de la phase d'intégration INT, on peut commander le commutateur SW :
- soit à l'état ouvert (transistor bloqué) de sorte à transférer les charges photogénérées vers le noeud SN11 uniquement, le circuit de commande 900 présentant dans ce cas un fonctionnement similaire à celui du circuit 400 ; ou
- soit à l'état fermé (transistor passant), de sorte à répartir le transfert des charges photogénérées vers les noeuds SN11 et SN12, qui équivalent dans ce cas à un unique noeud présentant une capacité environ égale au double de la capacité d'un seul des noeuds SN11 et SN12.

Cela permet avantageusement de bénéficier d'une double dynamique, c'est-à-dire d'accéder à deux gammes d'un couple formé par les paramètres « gamme d'intensité lumineuse » et « précision ».

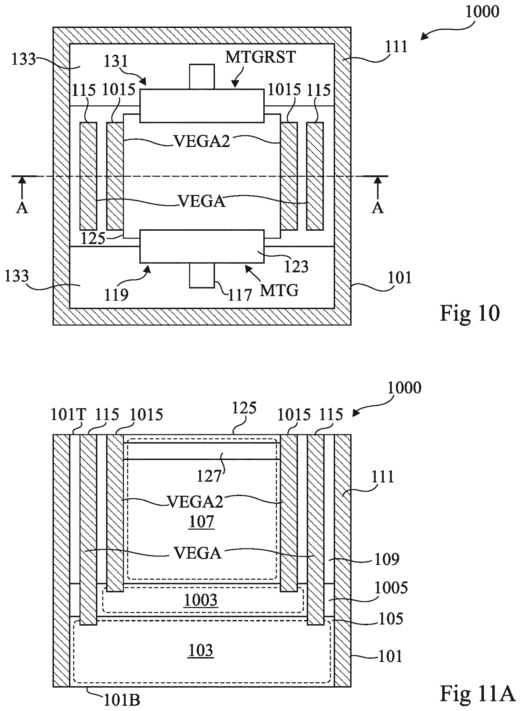

La figure 10 est une vue de dessus, schématique et partielle, d'un photosite 1000 de capteur d'images selon encore un autre mode de réalisation. La figure 11A est une vue en coupe, selon le plan AA de la figure 10, du photosite 1000 de la figure 10.

Le photosite 1000 des figures 10 et 11A comprend des éléments communs avec le photosite 100 des figures 1, 2A et 2B. Ces éléments communs ne seront pas décrits à nouveau ci-après. Le photosite 1000 des figures 10 et 11A diffère du photosite 100 des figures 1, 2A et 2B en ce que le photosite 1000 comprend une troisième zone photosensible 1003 formée dans le substrat semiconducteur 101 et interposée entre les première et deuxième zones photosensibles 103 et 107. La troisième zone photosensible 1003 est située à l'aplomb des première et deuxième zones photosensibles 103 et 107 (au-dessus de la première zone photosensible 103 et au-dessous de la deuxième zone photosensible 107, dans l'orientation de la figure 11A). Vue de dessus, la troisième zone photosensible 1003 présente par exemple un pourtour de forme sensiblement rectangulaire. La troisième zone photosensible 1003 présente par exemple des dimensions latérales inférieures à celles de la première zone photosensible 103. Plus précisément, en vue de dessus, le rectangle formé par la troisième zone photosensible 1003 s'étend entre les tranchées 115 de la grille VEGA et entre les deux murs opposés de la tranchée d'isolation périphérique 111 perpendiculaires aux tranchées 115. La troisième zone photosensible 1003 est par exemple formée dans une septième région 1005 du substrat 101 dopée du premier type de conductivité, le type N dans cet exemple, et présentant un niveau de dopage N5. Le taux de dopage N5 de la septième région 1005 du substrat 101 est par exemple supérieur au niveau de dopage N1 de la première région 105 et inférieur au niveau de dopage N2 de la deuxième région 109. Dans l'exemple représenté, la septième région 1005 du substrat 101 est en contact, par sa face inférieure, avec la face supérieure de la première région 105 sous-jacente et en contact, par sa face supérieure, avec la face inférieure de la deuxième région 109 sus-jacente. En outre, dans cet exemple, la troisième zone photosensible 1003 est sensiblement en contact, par sa face inférieure, avec la face supérieure de la première zone photosensible 103 sous-jacente et sensiblement en contact, par sa face supérieure, avec la face inférieure de la deuxième zone photosensible 107 sus-jacente.

La troisième zone photosensible 1003 fait par exemple partie d'une troisième diode photosensible D3, par exemple une photodiode pincée présentant une tension de pincement Vpin3. Dans cet exemple, la tension de pincement Vpin3 de la troisième photodiode D3 est supérieure à la tension de pincement Vpin1 de la première photodiode D1 et inférieure à la tension de pincement Vpin2 de la deuxième photodiode D2.

Chaque zone photosensible 103, 107, 1003 du photosite 1000 est par exemple destinée à collecter des photons incidents, lors de phases d'illumination du capteur d'images dont fait partie le photosite 100, et à convertir ces photons en paires électron-trou. Dans cet exemple, la première zone photosensible 103 est adaptée à capter de la lumière dans une première gamme de longueurs d'onde, la deuxième zone photosensible 107 est adaptée à capter de la lumière dans une deuxième gamme de longueurs d'onde, différente de la première gamme de longueurs d'onde, et la troisième zone photosensible 1003 est adaptée à capter de la lumière dans une troisième gamme de longueurs d'onde. La troisième gamme de longueurs d'onde comprend par exemple les première et deuxième gammes de longueurs d'onde. À titre de variante, la troisième gamme de longueurs d'onde peut être comprise entre les première et deuxième gammes de longueurs d'onde.

Plus précisément, les première et deuxième zones photosensibles 103 et 107 sont par exemple destinées à capturer respectivement des images 2D et des images de profondeur d'une scène. À titre d'exemple, la première zone photosensible 103 du photosite 1000 est adaptée à capter de la lumière visible, par exemple de la lumière bleue, et la deuxième zone photosensible 107 du photosite 1000 est adaptée à capter un rayonnement infrarouge, par exemple un rayonnement infrarouge proche, lorsque le photosite 1000 est illuminé du côté de sa face inférieure 101B. La troisième zone photosensible 1003 du photosite 1000 est alors par exemple adaptée à capter à la fois de la lumière visible et un rayonnement infrarouge proche.

Dans l'exemple illustré en figures 10 et 11A, le photosite 1000 comporte, outre la grille de transfert VEGA adaptée à transférer les charges photogénérées dans la première zone photosensible 103 vers la troisième zone photosensible 1003, une autre grille de transfert verticale VEGA2 adaptée à transférer les charges photogénérées dans la troisième zone photosensible 1003 vers la deuxième zone photosensible 107. Plus précisément, un circuit de commande du photosite 1000 peut être utilisé pour appliquer alternativement, sur la grille de transfert verticale VEGA2 :
- un cinquième potentiel adapté à bloquer un transfert de charges depuis la troisième zone photosensible 1003 vers la deuxième zone photosensible 107 ; ou
- un sixième potentiel, différent du cinquième potentiel, adapté à permettre un transfert de charges depuis la troisième zone photosensible 1003 vers la deuxième zone photosensible 107.

Dans cet exemple, la grille de transfert verticale VEGA2 comprend deux tranchées d'isolation 1015 disjointes, par exemple des tranchées d'isolation capacitives. Comme illustré en figure 11A, chaque tranchée d'isolation 1015 de la grille de transfert verticale VEGA2 s'étend verticalement dans l'épaisseur du substrat semiconducteur 101 depuis la face supérieure 101T du substrat 101 jusqu'à la troisième zone photosensible 1003, et pénètre partiellement dans la troisième zone photosensible 1003 jusqu'à une profondeur inférieure à celle de la grille de transfert verticale VEGA. En d'autres termes, chaque tranchée d'isolation 1015 s'interrompt dans l'épaisseur de la septième région 1005 du substrat 101 et ne débouche pas dans la première région 105 du substrat 101. Dans cet exemple, chaque tranchée d'isolation 1015 traverse totalement la deuxième région 109 du substrat 101 et pénètre partiellement dans la septième région 1005.

Dans l'exemple représenté, les tranchées d'isolation 1015 forment deux plaques sensiblement parallèles entre elles et bordant deux faces latérales opposées de la deuxième zone photosensible 107. Dans cet exemple, les tranchées d'isolation 1015 sont en outre, vues de dessus, sensiblement parallèles à deux côtés opposés de la tranchée d'isolation périphérique 111 et aux tranchées d'isolation 115 de la grille de transfert verticale VEGA. Dans l'exemple représenté, la grille de transfert verticale VEGA entoure la grille de transfert verticale VEGA2, chaque tranchée 115 de la grille VEGA étant intercalée entre une tranchée 1015 de la grille VEGA2 et une paroi de la tranchée 111.

Chaque tranchée d'isolation 1015 de la grille de transfert verticale VEGA2 présente par exemple une structure analogue à celle des tranchées d'isolation 115 de la grille de transfert verticale VEGA. Plus précisément, bien que cela n'ait pas été détaillé en figures 10 et 11A, chaque tranchée d'isolation 1015 comporte par exemple une région électriquement conductrice, par exemple en silicium polycristallin ou en un métal, par exemple le cuivre, ou en un alliage métallique. En outre, chaque tranchée 1015 comporte par exemple une couche électriquement isolante revêtant les parois latérales et la face inférieure de la région électriquement conductrice. La région électriquement conductrice de chaque tranchée d'isolation 1015 est par exemple électriquement isolée de la région électriquement conductrice des tranchées 115 et de la tranchée d'isolation périphérique 111. Cela permet par exemple de polariser les régions électriquement conductrices des tranchées d'isolation 1015 indépendamment de la région électriquement conductrice des tranchées 115 et de la tranchée d'isolation périphérique 111.

La première zone de collecte de charges 117 du photosite 1000 est par exemple commune aux charges photogénérées dans les première, deuxième et troisième zones photosensibles 103, 107 et 1003.

À titre d'exemple, le photosite 1000 est par exemple associé à un circuit de commande identique ou similaire au circuit de commande 400 de la figure 4.

La personne du métier est capable de déduire le fonctionnement du photosite 1000 des figures 10 et 11A à partir du fonctionnement du photosite 100 des figures 1, 2A et 2B précédemment décrit en relation avec les figures 4 et 6. En particulier, l'évolution temporelle des signaux de commande est par exemple analogue à celui précédemment décrit en relation avec le chronogramme de la figure 6, mais comprend une étape supplémentaire d'élimination, dans un cas ou la troisième gamme de longueurs d'onde inclut les première et deuxième gammes de longueurs d'onde, ou de transfert, dans un cas où la troisième gamme de longueurs d'onde est comprise entre les première et deuxième gammes de longueurs d'onde, des charges photogénérées dans la troisième zone photosensible 1003. Plus précisément, l'étape d'élimination ou de transfert intervient par exemple après la lecture, sur le noeud SN1, des charges photogénérées par le rayonnement infrarouge et avant le transfert des charges photogénérées dans la photodiode D1 vers le noeud SN1, par exemple avant la commutation vers l'état haut du signal MODE à l'instant t4. Dans le cas où l'étape préalable à l'instant t4 est une étape d'élimination, la grille de transfert verticale VEGA2 est par exemple commutée vers l'état passant pour transférer les charges de la troisième zone photosensible 1003 vers la photodiode D2 puis vers le noeud 401 d'application du potentiel VRT, par exemple en ouvrant le transistor MTGRST ou en ouvrant successivement le transistor MTG puis le transistor MRST. L'adaptation du fonctionnement au cas où l'étape préalable à l'instant t4 est une étape de transfert est à la portée de la personne du métier à partir des indications ci-dessus.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, le mode de réalisation du photosite 1000 des figures 10 et 11A peut être combiné avec le mode de réalisation du photosite 800 de la figure 8.

Bien que l'on ait décrit ci-dessus des exemples de photosites 100, 800, 1000 dans lesquels les régions 105 et 109 du substrat 101 dans lesquelles sont formées les première et deuxième zones photosensibles 103 et 107 sont dopées du même type de conductivité, le type N dans cet exemple, on pourrait alternativement prévoir que les régions 105 et 109 présentent des types de conduction opposés. À titre d'exemple, la région 105 pourrait être dopée du premier type de conductivité, le type N dans cet exemple, et la région 109 pourrait être dopée du deuxième type de conductivité, le type P dans cet exemple. Dans ce cas, le transfert des charges depuis la première zone photosensible 103 vers la deuxième zone photosensible 107 s'effectuerait non pas dans le volume, comme dans le cas où les régions 105 et 109 sont du même type de conductivité, mais à travers des canaux situés le long des flancs des tranchées 115 de la grille de transfert verticale VEGA.

En outre, bien que l'on ait décrit ci-dessus des exemples de photosites 100, 800, 1000 dans lesquels la première zone photosensible 103 est adaptée à capter majoritairement de la lumière bleue, on pourrait alternativement prévoir que la première zone photosensible 103 soit adaptée à capter majoritairement de la lumière verte. Dans ce cas, on pourrait par exemple augmenter l'épaisseur de la première zone photosensible 103 par rapport à la deuxième zone photosensible 107, de sorte à optimiser l'absorption de la lumière verte dans la première zone photosensible 103.

Enfin, la mise en oeuvre pratique des modes de réalisation et variantes décrits est à la portée de la personne du métier à partir des indications fonctionnelles données ci-dessus. En particulier, les modes de réalisation décrits ne se limitent pas aux exemples particuliers de matériaux et de dimensions mentionnés dans la présente description.

## Revendications

1. Capteur d'images (300) comprenant une pluralité de photosites (100 ; 800 ; 1000) formés dans et sur un substrat semiconducteur (101), chaque photosite comportant :
- une première zone photosensible (103) formée dans le substrat semiconducteur et adaptée à capter de la lumière dans une première gamme de longueurs d'onde ;
- une deuxième zone photosensible (107) formée dans le substrat semiconducteur à l'aplomb de la première zone photosensible (103) et adaptée à capter de la lumière dans une deuxième gamme de longueurs d'onde, différente de la première gamme de longueurs d'onde ;
- une première zone (117) de collecte de charges photogénérées dans les première et deuxième zones photosensibles, disposée du côté d'une face (101T) du substrat opposée à la première zone photosensible (103) ;
- une première grille de transfert (VEGA), s'étendant verticalement depuis la première zone photosensible (103) jusqu'à ladite face (101T), adaptée à transférer les charges photogénérées dans la première zone photosensible (103) vers la deuxième zone photosensible (107) ; et
- une deuxième grille de transfert (119), s'étendant horizontalement sur ladite face (101T) à l'aplomb de la deuxième zone photosensible (107), adaptée à transférer les charges photogénérées depuis la deuxième zone photosensible (107) vers la première zone de collecte de charges (117).

2. Capteur selon la revendication 1, dans lequel la première grille de transfert (VEGA) comprend au moins des première et deuxième plaques parallèles entre elles, la deuxième zone photosensible (107) s'étendant latéralement depuis une face de la première plaque jusqu'à une face de la deuxième plaque située en regard de la première plaque.

3. Capteur selon la revendication 1 ou 2, dans lequel chaque photosite (800 ; 1000) comporte en outre :
- au moins une deuxième zone (132) de collecte de charges photogénérées dans la deuxième zone photosensible (107), disposée du côté de ladite face (101T) ; et
- au moins une troisième grille de transfert (131) s'étendant latéralement, sur ladite face (101T), à l'aplomb de la deuxième zone photosensible (107).

4. Capteur selon l'une quelconque des revendications 1 à 3, dans lequel chaque photosite (800 ; 1000) comporte en outre :
- une troisième zone photosensible (1003), interposée entre les première et deuxième zones photosensibles (103, 107) ; et
- une quatrième grille de transfert (VEGA2) s'étendant verticalement, depuis la troisième zone photosensible (1003), jusqu'à ladite face (101T) et adaptée à transférer les charges photogénérées dans la troisième zone photosensible (1003) vers la deuxième zone photosensible (107).

5. Capteur selon la revendication 4, dans lequel la première zone de collecte de charges (117) est commune aux charges photogénérées dans les première, deuxième et troisième zones photosensibles (103, 107, 1003).

6. Capteur selon la revendication 4 ou 5, dans lequel la première grille de transfert (VEGA) entoure la quatrième grille de transfert (VEGA2).

7. Capteur selon l'une quelconque des revendications 1 à 6, dans lequel chaque photosite (100 ; 800 ; 1000) comporte en outre une tranchée d'isolation périphérique (111) s'étendant verticalement dans le substrat semiconducteur (101), depuis ladite face (101T), et délimitant latéralement la première zone photosensible (103).

8. Capteur selon l'une quelconque des revendications 1 à 7, dans lequel chaque photosite (100 ; 800 ; 1000) comporte en outre un circuit de commande (400 ; 500 ; 900) configuré pour appliquer alternativement, sur la première grille de transfert (VEGA) :
- un premier potentiel adapté à bloquer un transfert de charges depuis la première zone photosensible (103) vers la deuxième zone photosensible (107) ; et
- un deuxième potentiel, différent du premier potentiel, adapté à permettre un transfert de charges depuis la première zone photosensible (103) vers la deuxième zone photosensible (107).

9. Capteur selon la revendication 8, dans lequel le circuit de commande (400 ; 500 ; 900) est configuré pour appliquer alternativement, sur la deuxième grille de transfert (119) :
- un troisième potentiel adapté à bloquer un transfert de charges depuis la deuxième zone photosensible (107) vers la première zone de stockage de charges (117) ; et
- un quatrième potentiel, différent du troisième potentiel, adapté à permettre un transfert de charges depuis la deuxième zone photosensible (107) vers la première zone de stockage de charges (117).

10. Capteur selon l'une quelconque des revendications 1 à 9, comprenant en outre une cinquième grille de transfert (819) s'étendant horizontalement sur ladite face (101T) à l'aplomb de la deuxième zone photosensible (107), la cinquième grille de transfert étant adaptée à transférer des charges photogénérées depuis la deuxième zone photosensible (107) vers une deuxième zone (817) de collecte de charges.

11. Capteur selon la revendication 10, dans lequel les deuxième et cinquième grilles de transfert (119, 819) sont successivement ouvertes lors d'une phase d'échantillonnage de charges photogénérées dans la deuxième zone photosensible (107).

12. Capteur selon la revendication 10 ou 11, dans lequel les deuxième et cinquième grilles de transfert (119, 819) sont reliées entre elles par un commutateur (SW).

13. Capteur selon l'une quelconque des revendications 1 à 12, dans lequel les premières et deuxièmes zones photosensibles (103, 107) des photosites (100 ; 800 ; 1000) du capteur sont destinées à capturer respectivement une image 2D et une image de profondeur d'une scène.

14. Capteur selon l'une quelconque des revendications 1 à 13, dans lequel les première et deuxième zones photosensibles (103, 107) sont dopées du même type de conductivité.

15. Capteur selon l'une quelconque des revendications 1 à 13, dans lequel la première zone photosensible (103) est dopée d'un premier type de conductivité et la deuxième zone photosensible (107) est dopée d'un deuxième type de conductivité, opposé au premier type de conductivité.

16. Dispositif comprenant :
- un capteur d'images (300) selon l'une quelconque des revendications 1 à 15 ;
- une source d'émission d'un rayonnement infrarouge ; et
- un circuit de commande de la source d'émission du rayonnement infrarouge et du capteur d'images.
